(19) **Europäisches Patentamt**

**European Patent Office**

**Office européen des brevets**

(11) Veröffentlichungsnummer: **0 084 075**
**B1**

(12) # EUROPÄISCHE PATENTSCHRIFT

(45) Veröffentlichungstag der Patentschrift:
24.09.86

(51) Int. Cl.⁴: **H 01 L 21/66**, G 01 B 11/06

(21) Anmeldenummer: **82100373.8**

(22) Anmeldetag: **20.01.82**

(54) **Verfahren zur Endpunktbestimmung der Schichtabtragung beim Entwickeln oder Ätzen von beschichteten Substraten und Einrichtung zur Durchführung des Verfahrens.**

(43) Veröffentlichungstag der Anmeldung:
27.07.83 Patentblatt 83/30

(45) Bekanntmachung des Hinweises auf die Patenterteilung:
24.09.86 Patentblatt 86/39

(84) Benannte Vertragsstaaten:
**DE FR GB**

(56) Entgegenhaltungen:
**DE-A-2 448 294**
**DE-A-2 750 421**
**US-A-4 203 799**

**NACHRICHTENTECHNIK-ELEKTRONIK, Band 29, Nr. 6, 1979, Berlin, K. VOJTECHOWSKI "Messung der Siliziumschichtdicke während der Abscheidung", Seiten 256-258**
**IBM TECHNICAL DISCLOSURE BULLETIN, Band 21, Nr. 2, Juli 1978, New York, P.S. HAUGE "Optical film thickness measurement tool", Seiten 884, 885**
**Patent Abstracts of Japan, Band 2, Nr. 100, 18. August 1978, Seite 1833C78**

(73) Patentinhaber: **International Business Machines Corporation, Old Orchard Road, Armonk, N.Y. 10504 (US)**

(72) Erfinder: **Hafner, Bernhard, Pirolweg 3, D-7031 Unterjettingen (DE)**
Erfinder: **Thiel, Klaus Peter, Einsteinstrasse 35, D-6108 Weiterstadt (DE)**
Erfinder: **Wenz, Guido, F., Richard- Wagner-Strasse 19, D-7031 Neuweiler (DE)**
Erfinder: **Wüstenhagen, Jürgen, F., Dr., Amsterdamer Strasse 7, D-7030 Böblingen (DE)**

(74) Vertreter: **Hoffmann, Klaus, Dr. rer. nat., Hoffmann . Eitle & Partner Patentanwälte Arabellastrasse 4, D-8000 München 81 (DE)**

## Beschreibung

Die Erfindung betrifft ein Verfahren zur interferometrischen Endpunktbestimmung der Schichtabtragung nach dem Oberbegriff von Anspruch 1 und eine Einrichtung zur Durchführung des Verfahrens.

Derartige Verfahren sind erforderlich, um den genauen Zeitpunkt der Abtragung von Schichten auf Substraten ermitteln zu können, beispielsweise den Zeitpunkt, an dem eine Quarzschicht auf einem Siliciummetallplättchen weggeätzt oder der belichtete Bereich einer Fotolackschicht auf Substraten bis zur Substratoberfläche abgetragen ist. Dabei bedient man sich vorzugsweise optischer Methoden, wobei in bekannter Weise das Interferenzverhalten von monochromatischen Strahlen zur Dickenbestimmung herangezogen wird. Ein derartiges Verfahren ist beispielsweise in Solid State Electronics Pergamon Press 1970, Band 13, auf den Seiten 957-960 beschrieben.

Bei einem weiteren bekannten Verfahren zur Endpunktbestimmung - im folgenden EPD-Verfahren genannt - wird ein Laserstrahl orthogonal auf die gelackte Oberfläche während des Entwicklungsvorganges gesandt. Dieser wird zum Teil an der abzutragenden Lackoberfläche, zum Teil auch an deren Untergrund, d.h. an der Oberfläche des Substrats, reflektiert. Die beiden reflektierten Strahlen interferieren miteinander, solange die Lackschicht kontinuierlich abgetragen wird und erzeugen eine periodisch in Form einer Sinus-Linie schwankende Spannung an einem Fotodetektor. Anschliessend verschwindet das sinusförmige Interferenzbild und zwar genau in dem Moment, in dem die Lackschicht von der Entwicklerflüssigkeit in den belichteten Bereichen bis auf die Substratoberfläche abgelöst ist. Durch eine geeignete elektronische Schaltung läßt sich in dieser Phase die Entwicklung unterbrechen, indem die Entwicklerflüssigkeit aus dem Tank, in dem die beschriebene Entwicklung stattfindet, abgepumpt und das Substrat neutralisiert wird.

Auf diese Weise läßt sich die Messung der abnehmenden Filmdicke bzw. die Bestimmung des Endpunktes als Ausgangssignal für die Unterbrechung des Entwicklungs- bzw. ätzvorganges verwenden. Ein derartiges Verfahren ist beispielsweise in IBM Technical Disclosure Bulletin, Band 17, Nr. 5, Oktober 1974, auf den Seiten 1342/43, beschrieben.

Beim EPD-Verfahren reduziert sich also die Sinuslinie des Interferenzbildes der reflektierten Meßstrahlen auf die Null-Linie, sobald die Fotolackschicht in den mittels einer Maske belichteten Bereichen des Substrats abgetragen ist. Bisher fand die Behandlung von Substraten der genannten Art meistens in Entwicklertanks statt, in denen gleichzeitig mehrere Substrate behandelt werden konnten. Der wesentliche Nachteil einer derartigen Tankentwicklung ist darin zu sehen, daß durch die wiederholte Einbringung von Substraten in den Entwicklertank Verunreinigungen unvermeidbar sind, die zu einer Qualitätsminderung führen. Man muß daher die Entwickler- bzw. Ätzflüssigkeit häufig erneuern. Daraus resultieren höhere Verfahrenskosten.

Es ist daher auch bereits ein Verfahren zum Entwickeln bzw. Ätzen von Substraten vorgeschlagen worden, bei welchem zur Vermeidung der beschriebenen Nachteile nicht im Tauchverfahren in einem Tank gearbeitet wird, sondern jeweils ein Substrat auf einem rotierenden Teller befestigt und mit frischer Entwickler- bzw. Ätzlösung besprüht wird, die anschliessend aus der Entwicklerkammer entfernt und je nach Ätz- oder Entwicklungsanwendung regeneriert und dem Verfahren anschliessend wieder zugeführt oder entsorgt wird.

Das Verfahren der Sprühentwicklung mit rotierendem Substrat ist auf ein einzelnes Substrat während eines Entwicklungsvorganges beschränkt. Dieser vermeintliche Nachteil des Einzelverfahrens gegenüber dem Tankentwicklungsverfahren als Batch-Prozess erweist sich bei einer genaueren Analyse sogar als Vorteil; zunächst ist der Einzelprozess zur Erzielung engerer Toleranzen dem Batch-Prozess vorzuziehen; dies auch wegen der dabei erzielbaren höheren Reinheit. Schließlich werden die Substrate großflächiger und damit der Einzelprozess wirtschaftlicher.

Schließlich ist auch der JP-A-5 365 276 ein Verfahren zur EPD-Bestimmung beim Aufdampfen von Schichten auf Halbhalterchips bekannt, bei welchem ein Strahlenbünden aus monochromatischem Licht an der bewegten Substratorbefläche ein Interferenzbild erzeugt, das einem Fotodetektor zugeleitet wird, der über eine Kontrolleinheit die Schichtbildung unterbricht, sobald die gewünschte Schichtdicke erreicht ist.

Zum Stand der Technik zur Sprühentwicklung bzw. Sprühätzung mit rotierendem Substrat wird auf das IBM Technical Disclosure Bulletin, Band 14, Nr. 9, Februar 1972, Seiten 2605/06 verwiesen.

Schwierigkeiten ergaben sich zunächst bezüglich der exakten Endpunktkontrolle bei der Sprühentwicklung mit rotierendem Substrat. Die Endpunktkontrolle bei der Tankentwicklung erfolgte nämlich über einen bestimmten Substratbereich. So wählte man beispielsweise ein bestimmtes "Meß-Chip" im Zentrum oder auch im Randbereich des Substrats aus und justierte den Laserstrahl genau auf diese Stelle, was keine Schwierigkeiten bereitete, da das Substrat im Tank an einem bestimmten Ort fixiert ist. Bei der Sprühentwicklung mit bewegtem Substrat befindet sich dagegen jeder theoretische Meßpunkt auf der Substratoberfläche zu jedem Zeitpunkt an einem anderen Ort, so daß eine Justierung des Meßstrahles auf einen bestimmten Substratbéreich bei der Sprühentwicklung bzw. Sprühätzung ausscheiden muß.

Außerdem befürchtete man, daß durch die vielfachen Brechungen und Beugungen des Meßstrahles an den kleinen Tröpfchen des Aerosols im Bereich des Sprühnebels ein so diffuses und verschwommenes Interferenzbild entsteht, daß dieses zur Bestimmung des Endpunktes des Entwicklungs- bzw. ätzvorganges nicht mehr verwendbar ist. Der Meßstrahl wird nämlich nicht nur auf seinem Weg durch den Sprühnebelbereich zur Substratoberfläche in eine Vielzahl von Teilstrahlen zerlegt, sondern muß auf seinem Weg als doppelt reflektierter Teilstrahl wieder das Sprühnebelfeld durchlaufen, wo er nochmals in eine größere Vielzahl von Teilstrahlen aufgespalten wird und so als breites Strahlenbündel den Sprühnebelbereich wieder verläßt.

Es ist daher das Ziel der Erfindung, ein Verfahren der im Oberbegriff von Anspruch 1 angegebenen Art so durchzuführen, daß unter Beibehaltung der Vorteile der Sprühentwicklung mit bewegtem Substrat eine korrekte Endpunktkontrolle des Entwicklungs- bzw. Ätzvorganges möglich ist.

Gemäß der Erfindung wird dieses Ziel mit einem Verfahren erreicht, welches durch die Merkmale von Patentanspruch 1 gekennzeichnet ist.

Es muß als überraschend angesehen werden, daß trotz der bei dem Verfahren mit rotierendem Substrat bezüglich der Endpunktkontrolle erwarteten Schwierigkeiten man mit einem schräg einfallenden monochromatischen Meßstrahl, der nicht auf eine bestimmte Stelle des Substrats justiert sein muß, ein Interferenzbild der reflektierten Strahlung erhält, welches eine einfache Auswertung wie bei einem stationären Substrat ermöglicht und ein ebenso gutes und scharfes Interferenzbild über die Zeitdauer der Schichtabtragung liefert, wie dies bei dem eingangs beschriebenen EPD-Verfahren, mit stationärem Substrat und Tankentwicklung, der Fall ist. Die einzige Voraussetzung für die Auswertung der breitgefächerten reflektierten Interferenzstrahlung ist hier die Anordnung eines großflächigen Detektors, der möglichst die gesamte reflektierte Strahlung erfaßt.

Es hat sich sogar gezeigt, daß das Verfahren nach der Erfindung zur Endpunktbestimmung noch effektiver gestaltet werden kann, wenn man den Meßstrahl nicht nur durch den Sprühnebel in mehrere Teilstrahlen aufspaltet, sondern wenn man bereits vor dem Eintreten des Meßstrahles in den Bereich des Sprühnebels eine Streulinse anordnet, die den Meßstrahl auf einen möglichst großen Bereich des Substrates verteilt.

Es kann angenommen werden, daß durch die Vielzahl der auf der Substratoberfläche befindlichen Meßpunkte, das sind alle belichteten Bereiche in der Fotolackschicht, die von einem Teilstrahl des monochromatischen Meßstrahles getroffen werden, der gleiche Effekt wie beim stationären EPD-Verfahren erzielt wird.

Das erfindungsgemäße Verfahren hat gegenüber dem vorbekannten Verfahren mit stationärem Entwicklertank zusätzlich zu den bereits genannten Vorteilen engerer Toleranzen und größerer Reinheit und dem weiteren Vorteil einer exakten Endpunktbestimmung jedes einzelnen Substrats, wie dies beim Batch-Prozess mit mehreren Substraten der Endpunktbestimmung jeweils nur auf dem vordersten Sbustrat möglich ist, den großen neuen Vorteil, daß es ohne besondere EPD-Meßfelder auskommt. Dies bedeutet, daß der Chip, der als Meßfeld herhalten mußte und für die Produktion ausschied, bei Anwendung des vorliegenden Verfahrens der Produktion zugeführt werden kann, zumindest in solchen Fällen, in denen das Verhältnis der geätzten bzw. entwickelten zur nichtgeätzten bzw. nichtentwickelten Fläche groß genug ist. In Sonderfällen, in denen dieses Verhältnis sehr klein ist (wenige Einzellinien) kann die zusätzliche Anordnung eines Meßfeldes auch bei der Durchführung des erfindungsgemäßen Verfahrens notwendig sein. Dieses muß dann in der Mitte des Wafers liegen.

Im folgenden wird das Verfahren anhand des in der Zeichnung dargestellten Beispiels einer Einrichtung zur Durchführung des Verfahrens erläutert, wobei zunächst auf den Aufbau der Einrichtung eingegangen wird. In der Zeichnung zeigen:

Fig. 1 den schematischen Aufbau der erfindungsgemäßen Einrichtung;

Fig. 2 den Aufbau der elektronischen EPD-Auswerteinrichtung

und

Fig. 3 den Spannungsverlauf am Ausgang des Fotodetektors 15.

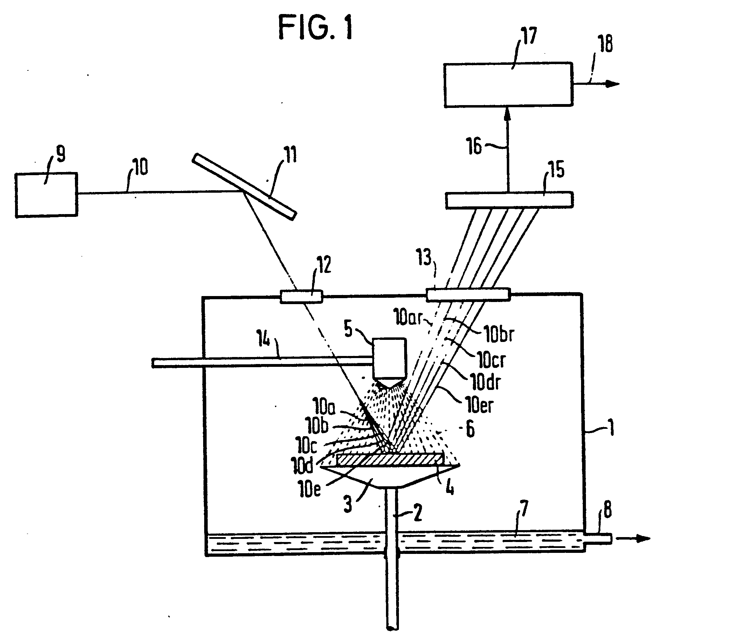

Wie man aus Fig. 1 erkennt, befindet sich in einem Tank 1 am Boden in der Mitte eine Öffnung zum Durchtritt der Drehachse 2, an deren oberem Ende ein Drehteller 3 zur Aufnahme einer Substratplatte 4 - Wafer - angeordnet ist. Die Drehachse 2 wird von einem in der Zeichnung nicht dargestellten Antriebsmotor mit einstellbarem Getriebe oder elektrischer Regelung in einem Bereich von 0 bis 10.000 Upm angetrieben. Es versteht sich, daß eine flüssigkeitsdichte Durchführung im Boden des Tanks 1 für die Drehachse 2 vorgesehen ist, um einen Austritt der Behandlungsflüssigkeit 7 (Ätz- oder Entwicklerflüssigkeit) zu verhindern. Die Flüssigkeit 7 tritt aus dem Sprühkopf 5 als fein verteilter Sprühnebel 6 aus, benetzt die Oberfläche des Substrats 4 und wird durch die Rotation des Drehtellers 3 vom Substrat abgeschleudert, sammelt sich am Boden des Tanks 1 als Bodensatz 7 an und wird durch die Leitung 8 zur Reinigung und Wiederaufbereitung abgeführt und in gereinigtem Zustand der im Arm 14 angeordneten Zuleitung zum Sprühkopf 5 wieder zugeführt. Alternativ kann auch die durch die Leitung 8 abgelaufene Flüssigkeit entsorgt werden und der Entwicklungs- oder ätzvorgang mit frischer Flüssigkeit durchgeführt werden.

Der Sprühkopf 5 ist an einem Gestänge 14 mechanisch so geführt, daß er bei Beendigung des Entwicklungsvorgünges aus dem Bereich des Drehtellers 3 ausschwenkbar ist. Wahlweise kann auch die Entwicklerzufuhr durch ein Magnetventil od. dgl. unterbrochen werden und im Anschluß daran eine neutralisierende Flüssigkeit oder eine Waschflüssigkeit wie Wasser auf das Substrat aufgesprüht werden.

Die Anordnung des Drehtellers 3 kann, wie in Fig. 1 gezeigt, stehend im Tank 1 vorgesehen sein; sie kann jedoch in bekannter Weise auch hängend vorgenommen werden, um die bekannten Vorteile einer solchen Anordnung wie Vermeidung einer Tropfenbildung auf der Oberfläche, leichteres Abfließen der Entwicklerflüssigkeit, zu erzielen. Soweit die mechanische Anordnung der Teile im Behälter 1.

Die Meßvorrichtung zur EPD-Bestimmung besteht aus der Meßstrahlenquelle 9, beispielsweise in Form eines Heliumgaslasers. Der monochromatische primäre Meßstrahl 10 läuft über einen Reflektor 11 in Form eines planparallelen Spiegels, an dessen Oberfläche er reflektiert wird und tritt durch das Fenster 12 in den Raum des Entwicklungsbehälters 1 ein. Wie erwähnt, kann anstelle des Fensters 12 auch eine in der Zeichnung nicht dargestellte Streulinse vorgesehen sein, die orthogonal im Meßstrahl 10 liegt.

Sobald der Meßstrahl 10 das Sprühfeld 6 erreicht, wird er in mehrere Teilstrahlen 10a, 10b, 10c, 10d, 10e... aufgespalten. Jeder dieser Teilstrahlen kann auf seinem Weg zur Oberfläche des Substrates 4 nochmals an weiteren Aerosoltröpfchen im Sprühnebelfeld 6 gebrochen und/oder gebeugt werden.

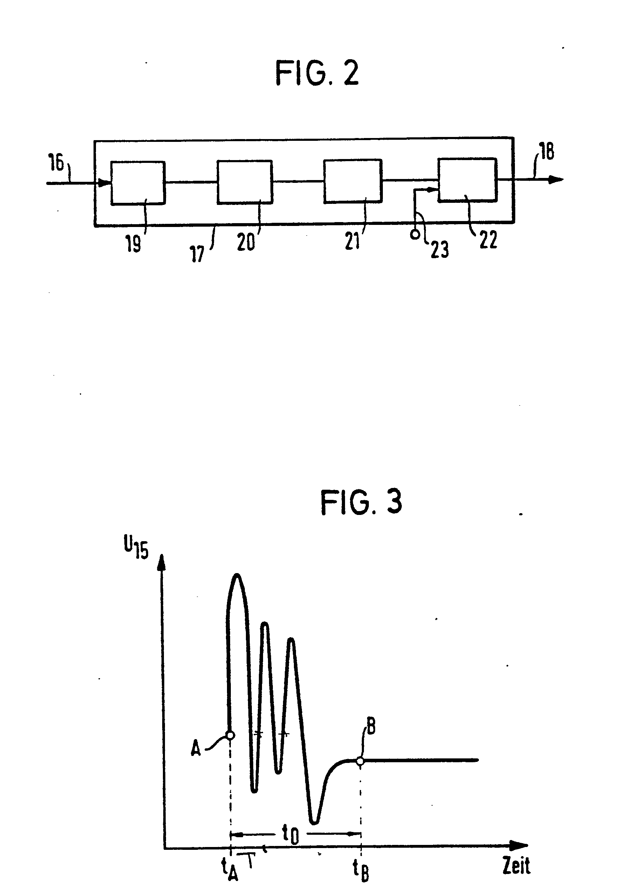

Alle diese Teilmeßstrahlen 10a, 10b, 10c, 10d, 10e... werden sowohl in den Bereichen der sich ständig verringernden belichteten Fotolackschicht oder der zu ätzenden Schicht als auch an der Substratoberfläche reflektiert. Diese beiden miteinander interferierenden reflektierten Strahlenbündel bilden Scharen der reflektierten Strahlen 10ar, 10br, 10cr, 10dr, 10er..., die ihrerseits im Sprühnebelfeld 6 weitergebeugt bzw. -gebrochen werden und so das Strahlenbündel bilden, welches durch das Fenster 13 aus dem Behälter 1 austritt und von dem großflächigen Detektor 15 aufgefangen wird. In der Praxis hat sich als großflächiger Detektor hier eine Silicium-Solarzelle mit einem Durchmesser der Empfangsfläche von 80 mm gut bewährt. Von dem Detektor 15 wird das Signal durch die Leitung 16 der EPD-Auswerteinheit 17 zugeführt, deren Aufbau im einzelnen in Fig. 2 angegeben ist.

Man erkennt in Fig. 2, daß die Leitung 16 zunächst in den Tiefpaßfilter 19 läuft, in dem die hohen Frequenzen ausgesiebt und nur niedrige Frequenzen unter 0,1 Hz durchgelassen werden, um höhere Störfrequenzen auszufiltern. Anschließend gelangt das Signal in den Gleichrichter 20 und von diesem in ein variabel einstellbares Zeitglied 21 und über den Komparator 22 mit Referenzspannung 23 in die Signalleitung 18, die das Relais zur Betätigung des Sprühkopfes bzw. zum Schalten des Magnetventils für die Behandlungsflüssigkeit steuert.

Das vom Fotodetektor 15 durch die Leitung 16 an die EPD-Auswerteinheit 17 abgegebene Signal ist in Fig. 3 dargestellt. Dabei handelt es sich um den Spannungsverlauf am Ausgang des Fotodetektors 15. Hier ist U15 gegen die Zeitachse aufgetragen. Zum Zeitpunkt $t_A$ beginnt der Entwicklungsprozess am Punkt A. Nach etwa drei Sinusschwingungen und einer Abklingphase ist zum Zeitpunkt $T_B$ der Endpunkt B der Entwicklung erreicht. Die gesamte Entwicklungszeit $t_0$ ergibt sich ohne weiteres aus der Beziehung $t_0 = t_B - t_A$. Die Periode der Sinusschwingung in Fig. 3 ist eine Funktion der Vakuumwellenlämge der monochromatischen Meßstrahlung und des Refraktionsindex der Fotolackschicht. Durch den Tiefpaßfilter 19 und den Gleichrichter 20 wird der Spannungsverlauf U15 gemäß Fig. 3 so transformiert, daß sich beim Erreichen des Entwicklungsendpunktes B eine Triggerschwelle mit folgendem Aufbau am Gleichrichterausgang ergibt, der am Ausgang des Komparators als rechteckiger Steuerimpuls das Relais in der beschriebenen Weise betätigt.

Durch das variabel einstellbare Zeitglied 21 kann der Zeitpunkt zur Abschaltung des Sprühkopfes 5 in gewissen Grenzen variiert werden. Das variabel einstellbare Zeitglied 21, welches wahlweise in der EPD-Auswerteinheit 17 zwischen dem Gleichrichter 20 und dem Komparator 22 eingeschaltet werden kann und in dem Ausführungsbeispiel gemäß Fig. 2 enthalten ist, dient zur lateralen Dimensionierungssteuerung der Entwicklung. Das variabel einstellbare Zeitglied 21 enthält einen einstellbaren Widerstand, vorzugsweise einen logarithmischen Potentiometer, dessen Skala bereits in μ-Meter kalibriert ist, wobei diese Kalibrierung der Abweichung von der liniengetreuen Entwicklung des Bildes von der Mastermaske entspricht.

Die genaue Einhaltung der Struktur, die von der Mastermaske auf die Substrate bzw. den lichtempfindlichen Fotolack in Form eines latenten Bildes kopiert und anschliessend geätzt bzw. entwickelt wird, ist für die Qualität und Genauigkeit der erzeugten Masken oder Wafer von hoher Bedeutung. Daher werden 16 bis 20 Kontrollmessungen pro Maske oder Wafer durchgeführt, um festzustellen, ob die laterale Schwankung innerhalb des Toleranzbereiches liegt. Während bei der Maskenherstellung im Tankentwicklungsverfahren laterale Schwankungsbreiten in der Größenordnung von 0,25 μ-Meter Δ/Maske auftreten, kann diese Schwankungsbreite bei der Sprühentwicklung erheblich bis auf etwa 0,06 μ-Meter Δ/Maske verbessert werden. Um außer einer engen Schwankungsbreite auch den gewünschten Sollwert der lateralen Strukturen zu erzielen, wird die "Überentwicklungs(ätz)zeit", das ist die Zeit, die nach Erreichen des Endpunktes B in Fig. 3 bis zum Ende der Entwicklung (Ätzung) verstreicht, mittels eines einstellbaren Potentiometers

proportional zur Zeit bis zum Erreichen des Punktes B eingestellt. Dieser Proportionalitätsfaktor dient zur Steuerung der Linienbreite.

## Patentansprüche

1. Verfahren zur Endpunktbestimmung der Schichtabtragung beim Entwicklen oder ätzen von beschichteten Substraten, insbesondere bei der Herstellung mikroelektronischer Bausteine (Chips) durch Auswerten des Interferenzbildes von auf der abzutragenden Oberfläche und der Substratoberfläche reflektierten Strahlenbündeln monochromatischen Lichts, wobei das Entwickeln oder ätzen mittels eines Sprühkopfes erfolgt, der die Entwickler- bzw. Ätzlösung fein verteilt auf die Oberfläche des bewegten Substrats aufspruht, dadurch gekennzeichnet, daß man das an der bewegten Substratoberfläche erzeugte reflektierte Interferenzbild des im Bereich (6) des Sprühnebels sowohl auf dem Hin- als auch auf dem Rückweg zum bzw. vom Substrat (4) in viele Teilstrahlen (10a, 10b... 10e) bzw. (10ar, 10br,... 10er) gebrochenen und gebeugten Meßstrahles (10) einem großflächigen Fotodetektor (15) zuleitet, von welchem Impulse einer EPD-Auswerteinheit (17) zugeführt werden und über eine Signalleitung (18) ein Relais zum Unterbrechen des Entwicklungs- bzw. Ätzvorgangs betätigt wird.

2. Einrichtung zur Durchführung des Verfahrens nach Anspruch 1, dadurch gekennzeichnet, daß dieselbe eine Meßstrahlenquelle (9), einen Spiegel (11), an dem der Meßstrahl (10) reflektiert wird, einen Entwicklungstank (1) mit einem Drehteller (3) zur Befestigung des Substrats (4) sowie einen Sprühkopf (5), der über einen Arm (14) aus dem Substratbereich herausbewegbar ist, wobei der Tank (1) zwei Fenster (12, 13) zum Eintritt des Meßstrahls (10) bzw. zum Austritt der gestreuten reflektierten Strahlen (10ar, 10br,.... 10er) hat und hinter dem Austrittsfenster ein großflächiger Detektor (15) sowie eine elektronische EPD-Auswerteinheit (17) angeordnet sind.

3. Einrichtung nach Anspruch 2, dadurch gekennzeichnet, daß die elektronische EPD-Auswerteinheit (17) ein Tiefpaßfilter (19), einen Gleichrichter (20), ein variabel einstellbares Zeitglied (21) sowie einen Komparator (22) enthält und daß die Signalleitung (18) ein oder mehrere Relais zur Bewegungssteuerung des Armes (14) für den Sprühkopf (5) bzw. zur Unterbrechung des Zuflusses der Entwickler- bzw. Ätzlösung betätigt.

4. Einrichtung nach einem der Ansprüche 2 oder 3, dadurch gekennzeichnet, daß im Boden des Behälters (1) eine Ableitung (8) vorgesehen ist, um die vom bewegten Substrat (4) abgeschleuderte Entwickler- bzw. Ätzflüssigkeit (7) über eine Einrichtung zum Regenerieren der im Arm (14) untergebrachten Zuleitung zum Sprühkopf (5) wieder zuzuführen.

5. Einrichtung nach einem oder mehreren der Ansprüche 2 bis 4, dadurch gekennzeichnet, daß der großflächige Detektor (15) eine Silicium-Solarzelle mit einer Empfangsfläche von mindestens 80 mm Durchmesser ist.

6. Einrichtung nach einem oder mehreren der Ansprüche 2 bis 5, dadurch gekennzeichnet, daß anstelle des Fensters (12) im Tank (1) eine orthogonal im vom Reflektor (11) reflektierten Meßstrahl (10) angeordnete Streulinse vorgesehen ist.

7. Einrichtung nach einem oder mehreren der Ansprüche 2 bis 6, dadurch gekennzeichnet, daß der Drehteller (3) mit einem außerhalb des Entwicklungsbehälters (1) angeordneten einstellbaren Antrieb mit einer Drehzahl zwischen 0 bis 10.000 Upm verbunden ist.

8. Einrichtung nach einem oder mehreren der Ansprüche 2 bis 7, dadurch gekennzeichnet, daß die Meßstrahlenquelle in bekannter Weise ein Heliumgaslaser ist.

## Claims

1. Process for the determination of the end point of layer removal in the developing or etching of layered substrates, especially in the production of microelectronic compontents (chips) by evaluation of the interference pattern generated by beams of monochromatic light reflected from the surface of the layer to be removed and the surface of the substrate, in which the developing or etching is effected by means of an actuator that sprays the developing or etching solution finely over the moving substrate, characterized in that the reflected interference pattern, produced on the moving substrate surface from the measuring beam (10) being, in the area (6) of the spray mist, split and bent into multiple component beams 10a, 10b... 10e) on its way to the substrate (4), and multiple component beams (10ar, 10br... 10er) after reflection from the substrate, is directed to a photo detector of wide surface area, from which impulses are transmitted to an end point determination evaluation unit (17) and a relay for the interruption of the developing or etching process is actuated via a signal line (18).

2. Apparatus for carrying out the process according to claim 1, characterized in that the said apparatus comprises a measuring beam source (9), a mirror (11), on which the measuring beam (10) is reflected, a developing tank (1) with a revolving table (3) for attaching the substrate (4) to, and an actuator (5), which may be removed from the area of the substrate by means of an arm (14), and in which the tank (1) has two windows (12, 13) to allow entry of the measuring beam (10) and exit of the scattered reflected beams (10ar, 10br... 10er) respectively and in which a large surface area detector (15) and an electronic end point determination evaluation unit (17) are arranged behind the exit window.

3. Apparatus according to claim 2, characterized in that the electronic end point determination evaluation unit (17) contains a lowpass filter (19), a rectifier (20), a variably adjustable time function element (21) as well as a compensator (22) and that the signal line (19) actuates one or more relays for steering the arm (14) for the actuator (5), or for interruption of the supply of the developing or etching solution.

4. Apparatus according to claim 2 or 3, characterized in that a drain (8) is provided for in the base of the receptacle (1) to return the developing or etching solution (7) spun off the moving substrate (4) back to the actuator (5) via a device for regenerating the supply of said solutions housed in the arm (14).

5. Apparatus according to any of claims 2 to 4, characterized in that the large surface area detector (15) comprises a silicon solar cell with a receptive area of at least 80 mm diameter.

6. Apparatus according to any of claims 2 to 5, chacterized in that instead of the window (12) in the tank (1) it is provided with a dispersion lens orientated at right angles to the measuring beam (10) reflected from the mirror (11).

7. Apparatus according to any of claims 2 to 6, characterized in that the rotating table (3) is connected to an adjustable driving gear with a rotational speed between 0 and 10.000 rpm which is disposed outside the development receptabcle (1).

8. Apparatus according to any of claims 2 to 7, characterized in that the measuring beam source is a known helium gas laser.

**Revendications**

1. Procécé de détermination du point final de dénudage des couches lors de développement ou de la gravure de substrats multicouches, en particulier lors de la fabrication de modules micro-électroniques (puces), par analuse de la figure d'interférence des pinceaux de lumière monochromatique réfléchis sur la surface à dénuder et sur la surface du substrat, procédé dans lequel le développement ou la gravure est réalisé à l'aide d'une tête de pulvéristation répartissant finement la soluton génératrice ou caustique sur la surface du substrat en mouvement, procédé caractérisé en ce que l'on transmet à un photodétecteur (15) de grande surface la figure d'interférence réfléchie, créée sur la surface du subsrat en mouvement, du faisceau de mesure diffracté (10) et separeé en nombreux petits faisceauz (10a, 10b,... 10e) et (10ar, 10br,... 10er) dans la région (6) du brouillard pulvérisé que ce soit sur le chemin aller en direction du substrat (4) ou sur le chemin de retour après réflexion sur ledit substrat, le photodétecteur (15) envoyant des impulsions à un analyseur EPD (17) qui les transmet sur une ligne (18) à relais commandant l'interruption du processus de développement ou de gravure.

2. Dispositif d'exécution du procédé selon revendicaton 1, caractérisé en ce qu'il regroupe une source de faisceau de mesure (9), un miroir (11) sur lequel le faisceau de mesure (10) se réfléchit, un bac de développement (1) contenant un plateau tournant (3) servant à la fixation du substrat (4) et une tête de pulvérisation (5) pouvant être déplacée au dessus du substrat à l'aide d'un bras (14), le bac (1) étant muni de deux fenêtres (12, 13) pour l'entrée du faisceau de mesure (10) et pour la sortie des faisceaux réfléchis diffusés (10ar, 10br,... 10er) un détecteur de grande surface (15) et une unité d'analyse EPD électronique (17) étant placés derrière la fenêtre de sortie.

3. Dispositif selon revendication 2, caractérisé en ce que l'unité d'analyse EPD électronique (17) contient un filtre passe-bas (19), un redresseur (20) un temporisateur réglable (21) et un comparateur (22), et en ce que la ligne (18) alimente un ou plusieurs relais de commande de déplacement du bras (14) supportant la tête de pulvérisation (5) ou de commande d'interruption de l'alimentation en solution génératrice ou caustique.

4. Dispositif selon une des revendications 2 ou 3, caractérisé en ce que dans le fond du bac (1) il est prévu une vidange (8) permettant de reconduire après regénération à la conduite placée dans le bras (14) et allant à la tête de pulvérisation (5) le liquide générateur ou caustique éjecté par le substrat (4) en mouvement.

5. Dispositif selon une des revendications 2 à 4, caractérisé en ce qué le détecteur de grande surface (15) est une cellule solaire au silicium dont la surface de réception est un cercle d'au moins 80 mm de diamètre.

6. Dispositif selon une des revendications 2 à 5, caractérisé en ce que la fenêtre (12) du bac (1) est remplacée par une lentille divergente placée perpendiculairement au faisceau de mesure (10) réfléchi par le réflecteur (11).

7. Dispositif selon une des revendications 2 à 6, caractérisé en ce que le plateau tournant (3) est relié à un groupe d'entraînement réglable entre 0 et 10 000 t/min placé à l'extérieur du bac de développement (1).

8. Dispositif selon une des revendications 2 à 7, caractérisé en ce que la source de faisceau de mesure est un laser à hélium connu en soi.

# FIG. 1

# FIG. 2

# FIG. 3